(19) Europäisches Patentamt / European Patent Office / Office européen des brevets

(11) **EP 2 315 507 A1**

(12) **EUROPEAN PATENT APPLICATION**

(43) Date of publication:
**27.04.2011 Bulletin 2011/17**

(51) Int Cl.:
*H05K 1/00* (2006.01)          *H05K 1/02* (2006.01)

(21) Application number: **09173828.6**

(22) Date of filing: **22.10.2009**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**
Designated Extension States:
**AL BA RS**

(72) Inventors:
• **Pieterse, Gerben**
  **5624 KL Eindhoven (NL)**
• **Giesen, Peter Theodorus Maria**
  **5662 VW Geldrop (NL)**

(74) Representative: **Hatzmann, Martin et al**
**Vereenigde**
**Johan de Wittlaan 7**
**2517 JR Den Haag (NL)**

(71) Applicant: **Nederlandse Organisatie voor Toegepast**
**-Natuurwetenschappelijk Onderzoek TNO**
**2628 VK Delft (NL)**

(54) **Apparatus and method for manufacturing devices on a flexible substrate**

(57)      A method for manufacturing devices on a flexible substrate is presented that comprises at least one set of the following steps:

a) Providing (S1) the flexible substrate with a first pattern by a first patterning process,

b) Transporting (S2) the flexible substrate with the first pattern,

c) Forming (S3) a spatial representation of the first pattern at the transported substrate,

d) Transforming (S4) said spatial representation into a frequency domain representation,

e) Determining (S5) at least one of an estimation of a deviation in scale and an estimation of a deviation in orientation relative to a reference pattern, by comparing said frequency domain representation with a frequency domain representation of the reference pattern,

f) Determining (S6) at least one control parameter on the basis of said at least one estimation,

g) applying (S7) a second patterning process to apply a second pattern at the substrate, the second patterning process being controlled by said at least one control parameter.

FIG. 1

**EP 2 315 507 A1**

**Description**

Field of the invention

The present invention relates to a method for manufacturing devices on a flexible substrate.
The present invention further relates to an apparatus for manufacturing devices on a flexible substrate.

Related Art

Devices on flexible substrates are applied more and more as they allow manufacturing in a roll to roll process. Examples of such devices are electronic components such as displays, RF-tags and batteries as well as optical components. In this process various patterning steps are carried out in a sequence. WO2007/106699 describes an apparatus and method for manufacturing electrical and optical materials by ink-jet printing on a flexible substrate in a roll to roll process. By way of example a patterned first layer of a conductive ink, a patterned second layer of a resistive ink and a patterned layer of an insulator ink are deposited. It is important that these patterning layers are mutually aligned to match mutually cooperating features in subsequent patterned layers. Small disalignments caused by mutual translations, rotations or scale changes between the patterned layers may be detrimental to the operation of the device. Such disalignments may easily occur in a roll to roll manufacturing system. For example a difference between the actual position of a pattern and the expected position of a pattern may result from deviations in the rotational speed of the rolls that transport the substrate or by slipping of the substrate at the surface of the rolls. Also a lateral shift sideways may occur, i.e. transverse to the transportation direction of the substrate. A deviation in scale may result from stretching of the substrate during transport and by temperature changes. In practice temperature changes occur in the substrate due to heat developed in various process steps or by contact with the rolls. This may also cause a deviation in position of the pattern. Slight rotations of the substrate may occur if the substrate moves sideways by a different amount at subsequent rolls. In a typical roll to roll system translation errors may be in the order of 100 to 1000 $\mu$m, while rotations in the order of 0.1 to 1.0° and stretching with 1 to 3% may occur. Although these deviations generally are relatively small, the consequences can be significant as patterns having details with a size of 100 $\mu$m and smaller are desired.
Accordingly, the cited document proposes application of alignment marks at the substrate that are detected by a camera to maintain alignment.
It is a disadvantage that these marks occupy space at the substrate that would otherwise be available for applying functional components. Moreover, often these alignment marks are applied in a separate processing step, which requires additional processing time.

SUMMARY OF THE INVENTION

According to a first aspect of the invention there is provided a method for manufacturing devices on a flexible substrate, which method comprises at least one set of the following steps:

    a) Providing (S1) the flexible substrate with a first pattern by a first patterning process,
    b) Transporting (S2) the flexible substrate with the first pattern,
    c) Forming (S3) a spatial representation of the first pattern at the transported substrate,
    d) Transforming (S4) said spatial representation into a frequency domain representation,
    e) Determining (S5) at least one of an estimation of a deviation in scale and an estimation of a deviation in orientation relative to a reference pattern, by comparing said frequency domain representation with a frequency domain representation of the reference pattern,
    f) Determining (S6) at least one control parameter on the basis of said at least one estimation,
    g) applying (S7) a second patterning process to apply a second pattern at the substrate, the second patterning process being controlled by said at least one control parameter.

According to a second aspect of the invention an apparatus is provided for manufacturing devices on a flexible substrate, the apparatus comprising at least:

    - a facility for providing a flexible substrate with a first pattern,
    - a facility for transporting the flexible substrate provided with the first pattern,
    - a facility for forming a spatial representation of the first pattern at the transported substrate,
    - a facility for transforming said spatial representation into a frequency domain representation,
    - a facility for determining at least one of an estimation of a deviation in scale and an estimation of a deviation in orientation relative to a reference pattern by comparison with a frequency domain representation of a reference pattern,
- a facility for determining at least one control parameter on the basis of said at least one estimation,
- a facility for applying a second pattern at the substrate that is controlled by said at least one control parameter.

The spatial representation of the first pattern at the substrate may be obtained with a camera. The frequency domain representation obtained from the spatial representation of the first pattern uses global visual information present in said first pattern. Therewith the method is robust, as local noise does not influence the result. Moreover, when using this method it is not necessary to add other visual information, like markers, than the visual information in patterns already present for functional purposes. The frequency domain representation of the reference pattern may be determined instantaneously, or may be obtained from a storage facility.

It is noted that a method for image registration using a frequency domain representation is known as such from Reddy et al., "An FFT-Based Technique for Translation, Rotation, and Scale-Invariant Image Registration", IEEE transactions on Image Processing, Vol. 5, No. 8, August 1996, pp. 1266-1271. Reddy et al. use this method to calculate a resultant image obtained by applying affine transformation on the highest resolution image with the parameters computed by the matching algorithm. Reddy does not teach or suggest to use the parameter obtained by the matching algorithm to control a patterning process.

The first pattern at the substrate may for example be a patterned layer at the substrate, for example by printing, e.g. inkjet printing. Alternatively the first pattern may be applied by modification of the surface of the substrate itself, for example by embossing or by radiation according to a pattern.

The production process that is controlled by its parameters is for example the printing of a subsequent layer upon the first patterned layer, but may alternatively be the process of laminating a foil with a patterned layer on the substrate, or the process of modifying the first patterned layer according to a further pattern.

The controlled parameter is for example the position and orientation of the printing head or a drive speed and tension applied to the substrate.

In an embodiment a two-roll system may be used wherein the flexible substrate is repeatedly transported backwards and forwards or a multi-roll system may be used wherein the substrate is substantially transported always in the same direction to undergo a subsequent process. The two-roll system may be relatively compact, while the multi-roll system is relatively fast as various processing steps can be carried out simultaneously. The substrate may be transported continuously, but may alternatively be transported stepwise.

In an embodiment of the method according to the first aspect of the invention the step of determining comprises the step of converting frequency axes of the frequency domain representation of the first pattern into a logarithmic scale and the step of determining a deviation in scale by comparison of said representation of the first pattern with a corresponding representation of the reference pattern. By the step of conversion into a logarithmic scale, scale deviations in the first pattern are represented as translations in the logarithmically scaled frequency domain representation. The translations can then subsequently be determined by phase correlation with the logarithmically scaled frequency domain representation of the reference pattern. This conversion step is useful if it is expected that the substrate is subject to stretching during the manufacturing process. The conversion step may be left out if no stretching or shrink of the substrate is expected, therewith simplifying computation.

In an embodiment of the method according to the first aspect of the invention the step of determining comprises the step of applying a Cartesian to polar representation of frequency axes of the frequency domain representation and determining a deviation in rotation by comparison of said representation of the first pattern with a corresponding representation of the reference pattern. By the step of applying a Cartesian to polar representation of frequency axes of the frequency domain representation deviations in orientation of the first pattern are represented as translations in the frequency domain. The translations can then subsequently be determined by phase correlation with the logarithmically scaled frequency domain representation of the reference pattern. This conversion step is useful if it is expected that the substrate is subject to rotations during the manufacturing process. This step may be left out if the influence of rotations is considered negligible, therewith simplifying computation

In an embodiment of the method according to the first aspect of the invention the step of determining comprises the step of converting frequency axes of the frequency domain representation into a logarithmic scale and the step of applying a Cartesian to polar representation of said logarithmically scaled frequency axes and determining a deviation in scale and rotation by comparison of said representation of the first pattern with a corresponding representation of the reference pattern. In this way both scale and angle deviations can be determined easily. In each case the corresponding representation of the reference pattern that is used for comparison may be determined instantaneously from the spatial representation of the reference pattern, but may alternatively be retrieved from a memory.

Methods according to these embodiments may further comprise the step of determining a spatial representation of the first pattern that is corrected for scale and rotation and the step of determining a correlation pattern by correlating said corrected spatial representation of the first pattern with a spatial representation of the reference pattern and determining an deviation in position from said correlation pattern. After compensation of the deviations in scale and/or orientation the deviation in position of the first pattern can be accurately determined from the position of the maximum in the correlation pattern. Noise, if present, may be corrected by a low-pass filter operation on the correlation pattern. Often, the important information on translation, rotation and scale deviations is expected to be represented in specific ranges of frequency and a frequency range filtering operation may be applied to enhance accuracy. The corrected spatial representation of the first pattern may be obtained by inverse rotating and/or scaling the spatial representation of the first pattern that was originally obtained. Alternatively the corrected spatial representation may be obtained by correcting the frequency domain representation for scale and/or rotation deviations and obtaining a corrected spatial representation of the first pattern by inverse Fourier transformation of the corrected frequency domain transformation. However, a more accurate result is obtained by directly applying the corrections at the spatial representations. Of course also a combination of these methods may be applied. For example the correction for rotation may be made in the frequency domain, while the correction for scaling is made in the spatial domain or the other way around.

BRIEF DESCRIPTION OF THE DRAWINGS

These and other aspects are described in more detail with respect to the drawings. Therein

FIG. 1 schematically shows a method according to the first aspect of the invention,
FIG. 2 schematically shows an embodiment of an apparatus according to the second aspect of the invention,
FIG. 3 shows in more detail a control part of the apparatus of FIG. 3,
FIG. 3A shows the control part in still more detail,
FIG. 4 shows a further embodiment of an apparatus according to the second aspect of the invention,
FIG. 5 more schematically shows the further embodiment as well as a control system therefore,
FIG. 6 shows the control system in more detail,

DETAILED DESCRIPTION OF EMBODIMENTS

In the following detailed description numerous specific details are set forth in order to provide a thorough understanding of the present invention. However, it will be understood by one skilled in the art that the present invention may be practiced without these specific details. In other instances, well known methods, procedures, and components have not been described in detail so as not to obscure aspects of the present invention.
In the drawings, the size and relative sizes of layers and regions may be exaggerated for clarity.
It will be understood that, although the terms first, second, third etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of the present invention.
Embodiments of the invention are described herein with reference to cross-section illustrations that are schematic illustrations of idealized embodiments (and intermediate structures) of the invention. As such, variations from the shapes of the illustrations as a result, for example, of manufacturing techniques and/or tolerances, are to be expected. Thus, embodiments of the invention should not be construed as limited to the particular shapes of regions illustrated herein but are to include deviations in shapes that result, for example, from manufacturing.
Unless otherwise defined, all terms (including technical and scientific terms) used herein have the same meaning as commonly understood by one of ordinary skill in the art to which this invention belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein. All publications, patent applications, patents, and other references mentioned herein are incorporated by reference in their entirety. In case of conflict, the present specification, including definitions, will control. In addition, the materials, methods, and examples are illustrative only and not intended to be limiting.
Throughout the description like parts have like reference numerals.

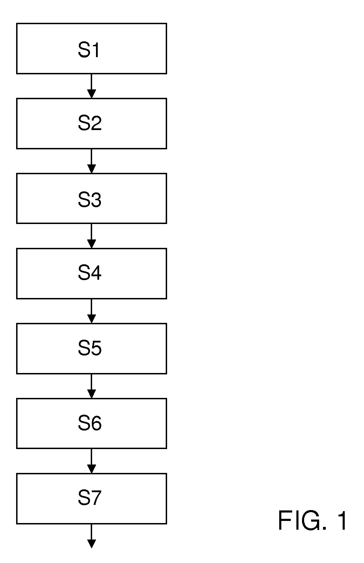

FIG. 1 schematically shows an embodiment of a method for manufacturing devices on a flexible substrate according to the first aspect of the invention. The method comprises a first step S1 wherein a flexible substrate is provided with a first pattern by a first patterning process. The substrate is for example polymer sheet, such as polyethylene therephtalate (PET) and polyethylene naphtalate (PEN). Alternatively a metal foil, e.g. a cupper, steel or aluminum foil may be used. Again other materials, e.g. a paper sheet or a woven material are suitable.
Various methods are applicable for applying the first pattern at the substrate. The first pattern may for example be applied as a patterned layer at the substrate. Such a patterned layer may be applied by applying a continuous layer and subsequently patterning said layer, e.g. by selective etching. Alternatively the layer may be applied by a patterned deposition process, e.g. using a shadowmask or for example by printing, e.g. inkjet printing. Instead of applying a patterned layer, the first pattern may be applied by modification of the surface of the substrate itself, for example by embossing or by radiating the surface according to a pattern.

In a second step S2 the flexible substrate is transported. Typically transport takes place by a system of rollers. The transport of the substrate may introduce deviations in the orientation of the pattern. Also the position of the pattern may deviate from the expected position after transport due to slip of the substrate in the transport system and lateral shifting of the substrate in the transport system for example. Stretching of the foil during transport may furthermore result in scale changes of the pattern.

In a third step S3 a spatial representation I(x,y) is formed of the first pattern at the transported substrate. The spatial representation may be obtained by a camera, or by a CCD scanner for example. The camera may observe a light transmittance pattern of light that is transmitted through the patterned substrate. Alternatively the camera may observe a light reflectance pattern of light that is reflected by the patterned substrate.

For a reliable operation the resolution of the spatial representation of the first pattern should be at least twice the most detailed elements in the first pattern. For example in case the pattern comprises conductive tracks having a width of 10 $\mu$m then the first pattern should be sampled at least once each 5$\mu$m. In the presence of noise or the like a higher sampling frequency should be selected to achieve the required accuracy. The spatial representation of the first pattern may be added with empty pixels, i.e. zero-padding, to enable sub-pixel accuracy of the alignment between the first and the second pattern. For an image having a size of NxM pixels the angular resolution is approximately equal to atan(1/MIN), wherein MIN is the minimum value of N and M. For an image having a size of N pixels in a direction, the scale resolution in that direction is approximately 1/N. For example for M,N is equal to 1000, the angular resolution is atan (1/1000) = 0.06°, and the scale resolution is 1/1000 = 0.1%.

Starting from this spatial representation I(x,y) an estimation of one or more of said deviations is made as follows.

In a fourth step S4 the spatial representation is transformed into a frequency domain representation, typically by a Fourier transformation. In practice a Fast Fourier Transform (FFT) is most suitable for this purpose.

Subsequently, by comparing said frequency domain representation with a frequency domain representation of the reference pattern at least one of an estimation of a deviation in scale and an estimation of a deviation in orientation relative to a reference pattern is determined in step S5.

In a sixth step S6 at least one control parameter is determined on the basis of said at least one estimation.

The at least one control parameter is used in a seventh step S7 to control a second patterning process that is used to apply a second pattern at the substrate.

Step S4 is described now in more detail.

First, a Fourier transform FI (u,v) of I(x,y) is obtained by

$$FI(u,v) = \frac{1}{NxNy} \sum_{x=1}^{Nx} \sum_{y=1}^{Ny} I(x,y) e^{-2\pi i x u / Nx} e^{-2\pi i x v / Ny}$$

In the same way a Fourier transform $FI_r$ of the reference image $I_r$ may be obtained.

It is not necessary to repeat the calculation of the transform $FI_r$ of the reference image, instead the transform $FI_r$ may be stored and reused.

Depending on the type of deviations that is expected, one or more of the following operations may be applied.

In case it is expected that stretching of the substrate occurred, a transformation to logarithmic scale may be applied. In the logarithmic scaled version scaling deviations are represented as translations. The translations can subsequently be estimated by a phase correlation technique. The deviations in scale a, b may subsequently be determined from the estimated translations as set out in Reddy et al. Likewise the logarithmic scaled version of the transform $FI_r$ may be stored and reused.

In case it is expected that rotation of the substrate occurred, a polar transformation may be applied. Therein the Fourier transformed images FI(u,v) and FIr(u,v) are represented in polar coordinates $\rho, \theta$, wherein u = psin $\theta$ and v = pcos $\theta$. In this representation a difference in angle between the images is represented as a translation.

The polar transformed version of the transform $FI_r$ may likewise be stored and reused.

The translation can be estimated using a phase correlation technique and the rotation of the substrate (angle) can be estimated using the estimation of the translation.

The estimated deviations in angle, scale and/or position are subsequently used to control the process.

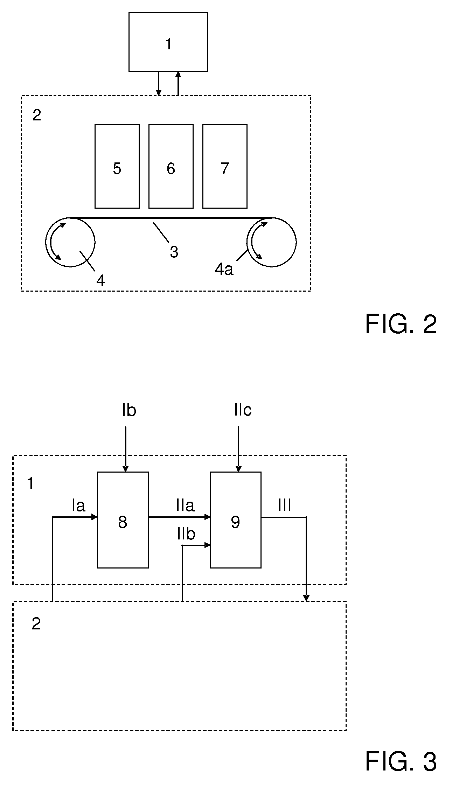

FIG. 2 schematically shows an apparatus according to the second aspect of the invention. The apparatus has a control part 1, here formed by a programmable processor and processing part 2. In the embodiment shown the processing part 2 comprises rollers 4,4a, a facility 5 for applying a substrate 3 with a first pattern, a facility 6 for forming a spatial representation, e.g. a camera and a facility 7 for applying the substrate 3 with a second pattern.

During operation the processed substrate 3 is transported from a supply or unwind roller 4 for supplying the flexible substrate 3 to a take-up roller 4a for winding the processed substrate.

During transport the substrate 3 passes the facility 5 for providing the flexible substrate with a first pattern. The rollers 4 and 4a form a facility for transporting the flexible substrate 3 provided with the first pattern.

The facility 6 then forms a spatial representation of the first pattern at the transported substrate.

The programmable processor 1 has a program memory with a program that enables it to transform said spatial representation into a frequency domain representation. The programmable processor 1 further has in its program memory a program that enables it to determine at least one of an estimation of a deviation in scale and an estimation of a deviation in orientation relative to a reference pattern by comparison with a frequency domain representation of a reference pattern. The programmable processor 1 has a program in its program memory that enables it to determine at least one control parameter on the basis of said at least one estimation.

The apparatus has a facility 7 for applying a second pattern at the substrate 3 that is controlled by said at least one control parameter.

Although in the embodiment shown the facility 6 for forming a spatial representation of the first pattern at the transported substrate 3 is arranged between the first facility 5 for providing the flexible substrate with a first pattern and the facility 7 for applying a second pattern at the substrate 3, the facility 6 for forming the spatial representation will in practice be arranged as closely as possible to the facility 7 for applying the second pattern. In a practical embodiment, wherein the substrate 3 is transparent, the facility 6 is arranged opposite the facility 7 for applying the second pattern.

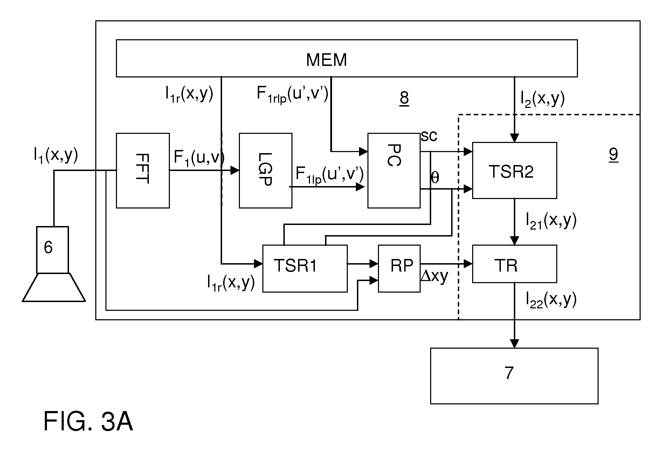

As illustrated in FIG. 3, dedicated hardware may be used for the control part 1 instead of a programmable processor. In FIG. 3, parts corresponding to those in FIG. 1 have the same reference number. In the embodiment shown part 8 is a first dedicated unit that receives an output signal Ia ($I(x,y)$ from the facility 6 that forms a spatial representation of the first pattern. The first dedicated unit 8 also receives information Ib related to a reference pattern. This information Ib may comprise frequency domain representation $Fr(u,v)$ of the reference pattern obtained from a storage facility. Alternatively the information Ib may comprise a spatial representation $Ir(x,y)$ of the reference pattern, and the first dedicated unit 8 may itself calculate the frequency domain representation $Fr(u,v)$ of the reference pattern. The information Ib may further include information representing user defined settings, e.g. filter settings that determine parameters of a high-pass prefilter. The first dedicated unit 8 further calculates an estimation of a deviation in scale and an estimation of a deviation in orientation relative to a reference pattern by comparison with a frequency domain representation of a reference pattern. In addition the second dedicated unit 8 may compute a deviation in position of the printed pattern. Information IIa, representing the estimation of the deviations, is provided to a second dedicated unit 9. The second dedicated unit 9 further may receive information IIb indicative for observed process parameters of the processing part 2. Furthermore the second dedicated unit may receive information IIc indicative for required settings. In response to the information IIa, IIb, IIc the second dedicated unit 9 calculates one or more control signals III for controlling the process part 2 of the apparatus.

FIG. 3A shows in more detail an embodiment of the units 8 and 9. Therein module FFT applies a fast fourier transform to the spatial representation $I_1(x,y)$ of the first pattern at the transported substrate 3. The fast fourier transformation results in an a frequency domain representation $F_1(u,v)$, In module LGP a log polar transformation is applied to this frequency domain representation $F_1(u,v)$ to obtain a log polar representation $F_{1lp}(u',v')$. This log polar representation $F_{1lp}(u',v')$, as well as a log polar representation $F_{1lp}(u',v')$ of a reference image $I_{1r}(x,y)$ for the captured representation $I_1(x,y)$ is provided to a phase correlation module PC. As a result the phase correlation module PC provides signals sc and $\theta$, respectively indicative for a deviation in scale and a deviation in rotation between the captured image $I_1(x,y)$ and the reference image. The log polar representation $F_{1rlp}(u',v')$ is obtained from a memory MEM, but may alternatively be calculated when needed from the reference image $I_{1r}(x,y)$. The obtained signals sc and $\theta$, indicative for a deviation in scale and a deviation in rotation are provided to a transformation unit TSR1 that applies the scaling and rotation sc and $\theta$ observed in the captured image $I_1(x,y)$ to the reference image $I_{1r}(x,y)$. Relative position comparison module RP calculates the relative position $\Delta xy$ of the captured image $I_1(x,y)$ with respect to the transformed reference image. Module 9 comprises a second transformation unit TSR2 that applies the scaling and rotation sc and $\theta$ observed in the captured image $I_1(x,y)$ to the second image $I_2(x,y)$ to obtain transformed second image $I_{21}(x,y)$. Subsequently module TR translates the transformed second image $I_{21}(x,y)$ to obtain a translated and transformed second image data $I_{22}(x,y)$. This image data $I_{22}(x,y)$ is subsequently used to control a pattern process 7, so that the features of the second pattern match those of the deformed and translated first pattern already present at the substrate 3. Instead of applying a translation to the transformed second image $I_{21}(x,y)$, the printer may be translated with respect to the substrate. Instead of applying a rotation to the second image data $I_2(x,y)$ a device, e.g. a printer, carrying out the pattern process may be rotated.

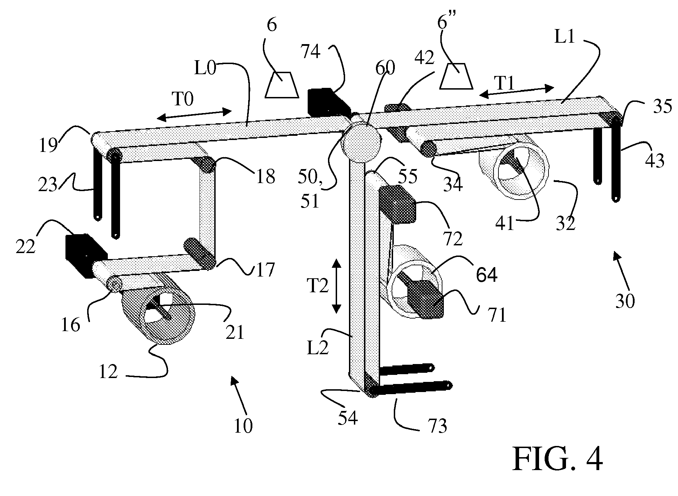

FIG. 4 shows an embodiment of the apparatus according to the invention wherein a laminating foil L1 is laminated onto a substrate foil L0 to form a laminated foil L2. Therein the second pattern is part of the foil L1 that is laminated onto the substrate L0 having the first pattern. The apparatus comprises a transporting facility 10 for transporting the substrate foil L0. In the embodiment shown the transporting facility 10 comprises a first supply roll 12 that is unrolled by motor 21 to supply the substrate foil L0. The unrolled substrate foil L0 is guided via a driving roll 16 and idler rolls 17, 18 along a sensor roll 19 that is mechanically coupled to a tension sensor 23. The tension sensor measures a tension T0 in the substrate foil L0 and the tension T0 is controlled by control of the motor 22 for the driving roll 16. The apparatus comprises a second facility 30 for transporting the laminating foil L1 with the second pattern. The second facility 30 includes a second supply roll 32 that is unrolled by motor 41 to supply the laminating foil L1 of material. The unrolled substrate foil L1 is guided via a driving roll 34 along a sensor roll 35 that is mechanically coupled to a tension sensor 43. The tension sensor measures a tension T1 in the laminating foil L1 and the tension T1 is controlled by control of the motor 42 for the driving roll 34. Subsequently the laminating foil L1 and the substrate foil L0 are pressed together by a pair of press-rolls 50, 51. The pair of press-rolls 50, 51 is driven by a motor 74 and their speed is measured by a speed sensor 60. The apparatus has a first and a second camera 6, 6" for determining a spatial representation of the first pattern at the substrate foil L0 and the second pattern at the laminating foil L1 respectively.

After lamination, a tension T2 in the laminated foil L2 is measured by tension sensor 73 coupled to sensor roll 54 and is controlled by control of the motor 72 for driving roll 55. The laminated foil L2 is wound upon a take-up roll 64 driven by motor 71.

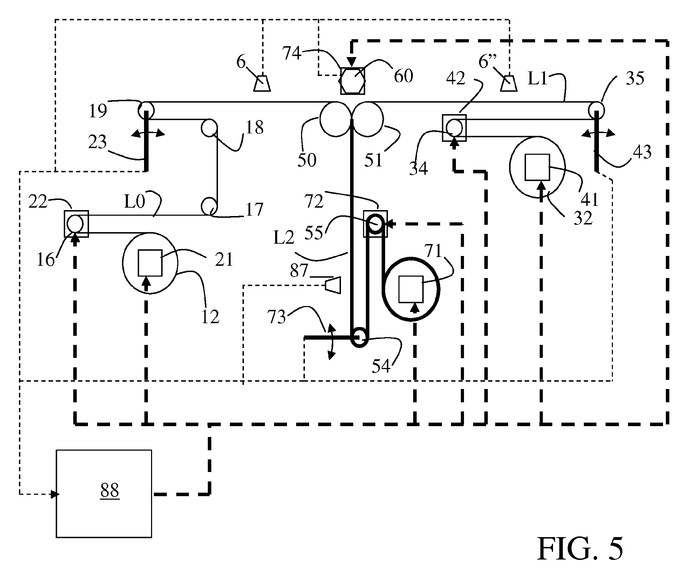

FIG. 5 shows a more schematic view of the apparatus according to FIG. 4, as well as a control facility 88 therefore. Parts therein corresponding to those in FIG. 4 have the same reference numerals. The control facility 88 receives input signals from the first and the second camera 6, 6" respectively. The control facility 88 further receives input signals (indicated by thin broken lines) from the velocity sensor 60, the tension sensors 23, 43 and 54 for sensing a value T0, T1, T2 of the tension in the substrate foil L0, the laminating foil L1 and the laminated foil L2 respectively, as well as a velocity signal from speed sensor 60. Optionally, camera 87 may be used for monitoring the alignment process. The controller 88 provides control signals (indicated by thick broken lines) to the motors 21, 22, 41, 42, 71, 72 and 74. Therewith the press rolls 50, 51 are controlled at a constant speed. In this embodiment it is assumed that the orientation of the patterns shows no deviations. However it is taken into account that the foils may stretch during processing. In addition it is taken into account that deviations in position may occur in the transportation direction x of the foil. Accordingly, in the embodiment shown the apparatus of FIG. 5 has a facility 6, i.e. a camera, for forming a spatial representation of the first pattern at the transported substrate foil L0. In addition the apparatus shown therein has a facility 6" for forming a spatial representation of the second pattern at the transported substrate foil L1.

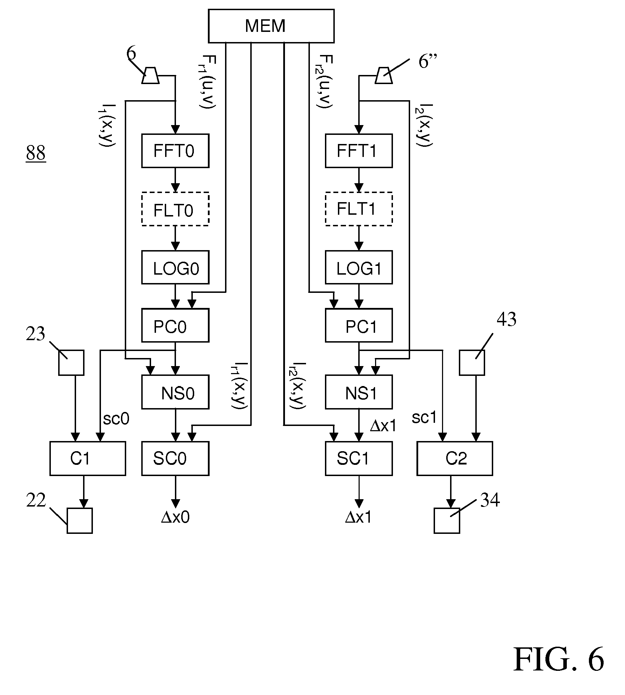

FIG. 6 shows the controller 88 in more detail. In the embodiment shown therein the controller 88 includes an FFT unit FFT0 for transforming the spatial representation $I_1(x,y)$ of the first pattern obtained by the camera 6 into a frequency domain representation. The controller 88 optionally has a filter FLT0, e.g. for selecting a frequency range that is expected to contain the highest signal to noise ratio. The controller has a logarithmic conversion module (LOGO) that converts the representation obtained by the FFT unit FFT0 (optionally modified by FLT0) into a logarithmic representation. I.e. a representation wherein the frequency spectrum of the first pattern as obtained by FFT0 and optionally FLT0 is represented in a logarithmic frequency coordinate system. As in this case it is expected that the foil L0 is only stretched in the x-direction, it is sufficient to calculate a linear to logarithmic conversion along the frequency axis u that corresponds to the x direction.

The so obtained (semi-) logarithmic frequency spectrum is compared in a phase correlation unit PC0 with the corresponding representation $F_{r1}(u,v)$ of the reference pattern as obtained from a memory unit MEM. The comparison involves a phase correlation between the spectra. The phase correlation on its turn is representative for a displacement in the (semi-) logarithmic frequency spectrum, which on its turn is representative for a difference in scale sc0 in the original linear frequency spectrum. The so obtained estimation sc0 is inversely related to the scale difference in the spatial representations of the first pattern and the reference pattern. This information is used by controller C1 to control the tension in the substrate foil L0 with motor 22. The controller C1 further uses the input signal of tension sensor 23 to verify that the tension T0 in the substrate foil remains within bounds.

The controller 88 further has a scale compensation unit NS0 that receives the spatial representation of the first pattern from the camera 6 and the estimation sc0 for the difference in scale between the first pattern and the reference pattern. In response the scale compensation unit NS0 compensates the spatial representation for scale changes and provides the so compensated representation to a spatial correlation unit SC0. The spatial correlation unit SC0 correlates the corrected spatial representation of the first pattern with a spatial representation $I_{r1}(x,y)$ of the reference pattern and determines a deviation $\Delta x0$ in position from the correlation pattern between the images.

The controller has further units FFT1, optional FLT1, LOG1, PC1, NS1, SC1 that calculate a difference in scale sc1 and in position $\Delta x1$ of the second pattern at the laminating foil on the basis of the spatial representation $I_2(x,y)$ of the second pattern obtained by camera 6" and information $I_{r2}(x,y)$, $F_{r2}(u,v)$ from a second reference pattern obtained from memory MEM. Likewise a further controller C2 is present that controls actuator 34 responsive to the input signal sc1 and that uses the input signal of tension sensor 43 to verify that the tension T1 in the laminating foil remains within bounds. Various units may be shared. E.g. an FFT unit may be time-shared to provide the functionality of FFT0 and of FFT1.

While the invention has been illustrated and described in detail in the drawings and foregoing description, such illustration and description are to be considered illustrative and exemplary and not restrictive; the invention is not limited to the disclosed embodiments.

Other variations to the disclosed embodiments can be understood and effected by those skilled in the art in practicing the claimed invention, from a study of the drawings, the disclosure and the appended claims. In the claims the word "comprising" does not exclude other elements or steps, and the indefinite article "a" or "an" does not exclude a plurality. A single processor or other unit may fulfill the functions of several items recited in the claims. The mere fact that certain measures are recited in mutually different claims does not indicate that a combination of these measures cannot be used to advantage. Any reference signs in the claims should not be construed as limiting the scope.

## Claims

1. A method for manufacturing devices on a flexible substrate, which method comprises at least one set of the following steps:

   a) Providing (S1) the flexible substrate with a first pattern by a first patterning process,
   b) Transporting (S2) the flexible substrate with the first pattern,
   c) Forming (S3) a spatial representation of the first pattern at the transported substrate,
   d) Transforming (S4) said spatial representation into a frequency domain representation,
   e) Determining (S5) at least one of an estimation of a deviation in scale and an estimation of a deviation in orientation relative to a reference pattern, by comparing said frequency domain representation with a frequency domain representation of the reference pattern,
   f) Determining (S6) at least one control parameter on the basis of said at least one estimation,
   g) applying (S7) a second patterning process to apply a second pattern at the substrate, the second patterning process being controlled by said at least one control parameter.

2. A method according to claim 1, wherein the step of determining (S6) comprises the step of converting frequency axes of the frequency domain representation of the first pattern into a logarithmic scale and determining a deviation in scale by comparison of said representation of the first pattern with a corresponding representation of the reference pattern.

3. A method according to claim 1, wherein the step of determining (S6) comprises the step of applying a Cartesian to polar representation of frequency axes of the frequency domain representation and determining a deviation in rotation by comparison of said representation of the first pattern with a corresponding representation of the reference pattern.

4. A method according to claim 1, wherein the step of determining (S6) comprises the step of converting frequency axes of the frequency domain representation into a logarithmic scale and the step of applying a Cartesian to polar representation of said logarithmically scaled frequency axes and determining a deviation in scale and rotation by comparison of said representation of the first pattern with a corresponding representation of the reference pattern.

5. A method according to claim 2, 3 or 4, further comprising the step of determining a spatial representation of the first pattern that is corrected for scale and rotation and the step of determining a correlation pattern by correlating said corrected spatial representation of the first pattern with a spatial representation of the reference pattern and determining an deviation in position from said correlation pattern.

6. Apparatus for manufacturing devices on a flexible substrate, the apparatus comprising at least:

   - a facility (5) for providing a flexible substrate (3) with a first pattern,
   - a facility (4, 4a) for transporting the flexible substrate (3) provided with the first pattern,
   - a facility (6) for forming a spatial representation of the first pattern at the transported substrate,
   - a facility (FFT) for transforming said spatial representation into a frequency domain representation,
   - a facility (LGP, PC) for determining at least one of an estimation (sc) of a deviation in scale and an estimation ($\theta$) of a deviation in orientation relative to a reference pattern by comparison with a frequency domain representation ($F_{1rlp}(u',v')$) of a reference pattern,
   - a facility (TSR2, TR) for determining at least one control parameter ($I_{22}(x,y)$) on the basis of said at least one estimation,
   - a facility (7) for applying a second pattern at the substrate (3) that is controlled by said at least one control parameter ($I_{22}(x,y)$).

**7.** An apparatus according to claim 6, comprising a facility (LGP) for converting the frequency domain representation $(F_1(u,v))$ of the first pattern into a representation $(F_{1lp}(u',v'))$ in a logarithmic scaled frequency domain and for determining an estimation (sc) of a deviation in scale by comparison of the representation of the first pattern with a corresponding representation $(F_{1rlp}(u',v'))$ of the reference pattern in the logarithmically scaled frequency domain.

**8.** An apparatus according to claim 6, comprising a facility (LGP) for converting the frequency domain representation $(F_1(u,v))$ of the first pattern into a further representation $(F_{1lp}(u',v'))$ obtained by a Cartesian to polar conversion of the frequency axes of the frequency domain and determining an estimation ($\theta$) for a deviation in rotation by comparison of said representation of the first pattern with a corresponding representation $(F_{1rlp}(u',v'))$ of the reference pattern.

**9.** An apparatus according to claim 6, comprising a facility (LGP) for converting the frequency domain representation $(F_1(u,v))$ of the first pattern into a representation $(F_{1lp}(u',v'))$ in a logarithmic scaled and Cartesian to polar converted frequency domain and for determining an estimation (sc) for deviation in scale and an estimation for a deviation ($\theta$) in rotation by comparison of said representation of the first pattern with a corresponding representation $(F_{1rlp}(u',v'))$ of the reference pattern.

**10.** An apparatus according to claim 7, 8 or 9, further comprising a facility (NS0) for determining a spatial representation of the first pattern that is corrected for scale and rotation and a facility (SC0) for determining a correlation pattern by correlating said corrected spatial representation of the first pattern with a spatial representation of the reference pattern and determining from said correlation pattern an estimation ($\Delta$x0) for a deviation in position.

**11.** An apparatus according to claim 7, 8 or 9, further comprising a facility (TSR1) for transforming a reference image $(I_{1r}(x,y))$ for the first pattern by applying to the reference image $(I_{1r}(x,y))$ a scaling and/or a rotation that corresponds to the estimated amount (sc,$\theta$) thereof and a facility (RP) for determining a correlation pattern by correlating said transformed reference image with an observed version $(I_1(x,y))$ of the first pattern and for determining from said correlation pattern an estimation ($\Delta$xy) for a deviation in position.

FIG. 1

FIG. 2

FIG. 3

FIG. 3A

FIG. 4

FIG. 5

FIG. 6

| | Europäisches Patentamt European Patent Office Office européen des brevets | **EUROPEAN SEARCH REPORT** | Application Number EP 09 17 3828 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 7 418 157 B1 (MAHANY RICHARD J [US]) 26 August 2008 (2008-08-26) * column 1, line 63 - column 2, line 9; claim 1; figure 1 * | 1,6 | INV. H05K1/00 H05K1/02 |
| A | US 2004/081351 A1 (GANOT AMNOT [IL] ET AL) 29 April 2004 (2004-04-29) * paragraph [0082] - paragraph [0093]; figure 5a * | 1,6 | |
| A | US 2008/052925 A1 (HIRASHIMA TAKUYA [JP]) 6 March 2008 (2008-03-06) * paragraph [0050] - paragraph [0057]; figures 1,5 * | 1,6 | |
| A | WO 02/39793 A2 (ORBOTECH LTD [IL]; GANOT AMNON [IL]; GINO HANAN [IL]; HANINA GOLAN [IL] 16 May 2002 (2002-05-16) * page 11, line 16 - page 15, line 16; claim 1; figure 5a * | 1,6 | |
| A | WO 03/094582 A2 (ORBOTECH LTD [IL]; HANINA GOLAN [IL]; GINO HANAN [IL]; RUECKER STEFFEN) 13 November 2003 (2003-11-13) * claims 1-11; figures 2-4 * | 1,6 | TECHNICAL FIELDS SEARCHED (IPC) H05K |
| A | WO 2006/036020 A1 (FUJI PHOTO FILM CO LTD [JP]; OKUTSU HIROKAZU [JP]) 6 April 2006 (2006-04-06) * claims 1-18 * | 1,6 | |

The present search report has been drawn up for all claims

| Place of search | Date of completion of the search | Examiner |
|---|---|---|
| Munich | 8 March 2010 | Lehnberg, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

## ANNEX TO THE EUROPEAN SEARCH REPORT
## ON EUROPEAN PATENT APPLICATION NO.

EP 09 17 3828

This annex lists the patent family members relating to the patent documents cited in the above-mentioned European search report.
The members are as contained in the European Patent Office EDP file on
The European Patent Office is in no way liable for these particulars which are merely given for the purpose of information.

08-03-2010

| Patent document cited in search report | | Publication date | Patent family member(s) | | Publication date |
|---|---|---|---|---|---|
| US 7418157 | B1 | 26-08-2008 | NONE | | |
| US 2004081351 | A1 | 29-04-2004 | NONE | | |
| US 2008052925 | A1 | 06-03-2008 | CN 101135862 A | | 05-03-2008 |
| | | | JP 2008058797 A | | 13-03-2008 |
| | | | KR 20080020935 A | | 06-03-2008 |
| WO 0239793 | A2 | 16-05-2002 | AU 1424102 A | | 21-05-2002 |
| | | | JP 2004523101 T | | 29-07-2004 |
| | | | TW 246382 B | | 21-12-2005 |
| | | | US 2003190071 A1 | | 09-10-2003 |
| WO 03094582 | A2 | 13-11-2003 | AU 2003224400 A1 | | 17-11-2003 |
| | | | CN 1659417 A | | 24-08-2005 |
| | | | DE 10392578 T5 | | 12-05-2005 |
| | | | JP 2005524982 T | | 18-08-2005 |
| | | | US 2005213806 A1 | | 29-09-2005 |
| WO 2006036020 | A1 | 06-04-2006 | JP 2006106097 A | | 20-04-2006 |
| | | | KR 20070098990 A | | 08-10-2007 |
| | | | US 2008094465 A1 | | 24-04-2008 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2007106699 A

### Non-patent literature cited in the description

- **Reddy et al.** An FFT-Based Technique for Translation, Rotation, and Scale-Invariant Image Registration. *IEEE transactions on Image Processing,* August 1996, vol. 5 (8), 1266-1271